(19) Europäisches Patentamt
European Patent Office
Office européen des brevets

(11) **EP 2 916 464 A1**

(12) **EUROPEAN PATENT APPLICATION**

(43) Date of publication:
**09.09.2015 Bulletin 2015/37**

(51) Int Cl.:
*H04B 3/54* (2006.01)    *G01D 4/00* (2006.01)

(21) Application number: **14305312.2**

(22) Date of filing: **05.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Thomson Licensing**
**92130 Issy-les-Moulineaux (FR)**

(72) Inventors:
• **Louzir, Ali**
**35 576 Cesson Sévigné (FR)**

• **Le Naour, Jean-Yves**
**35 576 Cesson Sévigné (FR)**
• **Robert, Jean-Luc**
**35830 Betton (FR)**

(74) Representative: **Browaeys, Jean-Philippe**
**Technicolor**
**1, rue Jeanne d'Arc**
**92443 Issy-les-Moulineaux (FR)**

(54) **Electrical activity sensor device for detecting electrical activity and electrical activity monitoring apparatus**

(57)    An electrical activity sensor device for monitoring the electrical status of an electrical device, the device comprising: a power cable for supplying power to an electrical device from a power supply network, the power cable being fitted with an in-line switch enabling the electrical device to be switched between electrical power states; an RFID tag device attached to the power cable of the electrical device, the RFID tag device including: an antenna element operable to magnetically couple with an electrical pulse generated in the power cable in response to the switching on of the electrical device; and a memory element for storing identification data identifying the RFID tag device; wherein: the antenna element is operable to transfer the identification data to the power cable; and the power cable is operable to operate as an antenna when the electrical device is switched on to transmit the identification data wirelessly to an RFID reader.

FIG. 1

**Description**

TECHNICAL FIELD

The present invention relates to an electrical activity sensor device for detecting the electrical activity of an electrical device connected to a power supply network, in particular the change in electrical power state and to an electrical activity monitoring apparatus for monitoring the electrical activity of one or more electrical devices. The electrical activity sensor device is based on a radio frequency identification device (RFID).

BACKGROUND

The monitoring of electrical activity of electrical devices finds many useful applications in areas such as energy consumption, building user activity profiles, and security or safety monitoring systems. For example, in a home environment knowledge of the activity of electrical appliances such as washing machines, lighting devices; cookers, toaster or a coffee machine may provide useful information on the household habits and user activity enabling a profile to be built up.
A known solution for monitoring the activity of electrical devices employs a complex electrical meter system based on remote controlled modules plugged into power outlets and configured to measure the electrical consumption of the electrical equipment powered from the respective power outlet. Such, remote controlled modules are typical equipped with a wireless communication system generally based on low power wireless technology to remotely monitor and control the corresponding electrical appliance. Such advanced meter systems require however a complex and expensive customized installation. Indeed, a recent research report on home automation and monitoring indicated price and technical complexity as being the main market hurdles and inhibitors against widespread adoption. Another drawback of such techniques is that electrical devices may be moved from one power outlet to another power outlet. Moreover some devices such as lighting devices are not always powered from a power outlet.
Other solutions for the detection of the activity of electrical devices are based on sensing their "EMI (electromagnetic interference) signature" by monitoring the powerlines at one or several points of the power supply network. These techniques require however a customised calibration and training process to learn the EMI signature of various devices. Moreover the EMI signatures may evolve with time. Complex signal processing techniques are required to disaggregate the signatures of the various active devices connected to the network and the obtained results are not always very accurate.
The present invention has been devised with the foregoing in mind.

SUMMARY

In a general form the invention concerns an electrical activity sensor device based on a radio frequency identification device (RFID) attached to a power cable wherein the power cable is configured to wirelessly transmit data to and to receive data from a remote RFID reader when the electrical device is in an ON state
According to a first aspect of the invention there is provided an electrical activity sensor device for monitoring the electrical status of an electrical device, the device comprising: a power cable for supplying power to an electrical device from a power supply network, the power cable being fitted with an in-line switch enabling the electrical device to be switched between electrical power states, for example between an electrical ON state and an electrical OFF state; an RFID tag device attached to the power cable of the electrical device, between the end of the power cable connectable to the power supply outlet and the in-line switch, the RFID tag device including: an antenna element operable to magnetically couple with the power cable when the electrical device is in an ON power state a memory element for storing identification data identifying the RFID tag device; wherein the power cable configured to operate as an antenna, when the electrical device is switched on, to transmit the identification data from the RFID tag device wirelessly to an RFID reader.
Detection of electrical activity can thus be provided in a simplified and low coast manner.. The operational range of the RFID tag device is extended since data is transmitted to an RFID reader wirelessly via the power cable. Data can be transmitted wirelessly to a remote RFID reader in response to an interrogation by the RFID reader.
In an embodiment the power cable, between the in-line switch and the end of the power cable connectable to the power supply is configured to operate as a transverse electric and magnetic mode (TEM) transmission line in the operating frequency range of the RFID sensor device when the electrical device is switched on.
In an embodiment the power cable comprises a pair of electrically conductive wires connected in parallel with a capacitive load provided at the in-line switch and a capacitive load provided at the end of the power cable connectable to the power supply network.
In an embodiment, the length of the power cable between the in-line switch and the end of the cable connectable to the power supply network is sized based on the operating frequency range of the RFID tag device.

In an embodiment, the said length corresponds to the resonant wavelength of the operating frequency of the RFID sensor device.

In an embodiment, the said length L3 is determined based on the following expression:

$$k3 \times \lambda/2;$$

where k3 is an integer and $\lambda$ is the guided wavelength corresponding to the operating frequency of the RFID tag device.

In an embodiment, the RFID tag device is attached to the power cable at a first distance *L1* from the end of the cable connectable to the power supply t and at a second distance L2 from the in-line switch such that

• 

$$L2 = k2 \times \lambda/2;$$

• 

$$L1 = k1 \times \lambda/2 + \lambda/4;$$

where k1, k2 are integers and $\lambda$ is the guided wavelength corresponding to the operating frequency of the RFID sensor device.

In an embodiment, the said length L3 and the first distance L1 and the second distance L2 are selected based on the following expression:

$$2(k2 + k1) + 1 \# 2k3$$

In an embodiment, the RFID tag device comprises a short range (near field) RFID tag. The use of a short range (near field) RFID tag combined with wireless transmission by the power cable enables power consumption to be reduced with respect to a long range (far field) RFID tag while enabling extended coverage to be provided by the power cable transmission.

In an embodiment, the antenna element is formed as a loop antenna. This improves coupling with the cable.

In an embodiment, the RFID sensor device is operable as a passive RFID tag powered by electromagnetic induction via the power cable. This enables power consumption to be reduced by avoiding the use of batteries.

According to a second aspect of the invention there is provided an electrical activity monitoring apparatus for monitoring the electrical status of at least one electrical device connected to a power supply network by a respective power cable and, the electrical activity monitoring apparatus comprising: an RFID reader module for reading RFID identification data from at least one RFID tag device, each RFID tag device being attached to a respective power cable of an electrical device between the end of the power cable connectable to the power supply outlet and an in-line switch fitted to the power cable to switch the electrical device between electrical power states, for example between an electrical ON state and an electrical OFF state, wherein the identification data is received from the respective RFID tag device via wireless transmission from the power cable to which the RFID tag device is attached; and a monitor device for determining from the RFID identification data received by the RFID reader module, which electrical devices of the network are switched on.

In an embodiment, the RFID reader module is configured to read signals from the at least one RFID tag in response to a detected change in power consumption measured by an electricity meter connected to the power supply network.

In an embodiment, a communication network interface is provided for connecting with a communication network such that data may be transmitted to or received from a remote server connected to the communication network.

In an embodiment the device is integrated in a gateway device.

In an embodiment the RFID reader module is configured to trigger the transmission of one or more interrogation signals in response to a command signal received via the communication network.

According to a further aspect of the invention there is provided a gateway system comprising an electrical activity monitoring apparatus according to any embodiment of the second aspect of the invention

According to a further aspect of the invention there is provided an electrical activity monitoring system comprising at least one electrical activity sensor device according to any embodiment of the first aspect of the invention for monitoring the electrical status of an electrical device, and an electrical activity monitoring apparatus according to any embodiment of the second aspect of the invention.

In an embodiment the electrical activity monitoring system further includes an electricity meter connected to the electrical activity monitoring apparatus for monitoring electrical power consumption in the power supply network.

In an embodiment the RFID reader module is configured to transmit interrogation signal to the RFID tag devices in response to a detected change in power consumption measured by the electricity meter.

In some embodiments of the invention timing means are provided to determine how long an electrical appliance has been switched ON or switched OFF.

Some processes implemented by elements of the invention may be computer implemented. Accordingly, such elements may take the form of an entirely hardware embodiment, an entirely software embodiment (including firmware, resident software, micro-code, etc.) or an embodiment combining software and hardware aspects that may all generally be referred to herein as a "circuit", "module" or "system'. Furthermore, such elements may take the form of a computer program product embodied in any tangible medium of expression having computer usable program code embodied in the medium.

Since elements of the present invention can be implemented in software, the present invention can be embodied as computer readable code for provision to a programmable apparatus on any suitable carrier medium. A tangible carrier medium may comprise a storage medium such as a floppy disk, a CD-ROM, a hard disk drive, a magnetic tape device or a solid state memory device and the like. A transient carrier medium may include a signal such as an electrical signal, an electronic signal, an optical signal, an acoustic signal, a magnetic signal or an electromagnetic signal, e.g. a microwave or RF signal.

BRIEF DESCRIPTION OF THE DRAWINGS

Embodiments of the invention will now be described, by way of example only, and with reference to the following drawings in which:

FIG. 1 is a schematic block diagram of an electrical activity monitoring system in which one or more embodiments of the invention may be implemented

FIG. 2 is a schematic diagram of an electrical activity sensor device in accordance with an embodiment of the invention;

FIG. 3 is a block diagram of an RFID tag device in accordance with an embodiment of the invention;

FIG. 4A to 4C are schematic diagrams of an RFID tag device in accordance with different embodiments of the invention; and

FIG. 5 is a schematic block diagram of an electrical activity monitoring apparatus in accordance with an embodiment of the invention

DETAILED DESCRIPTION

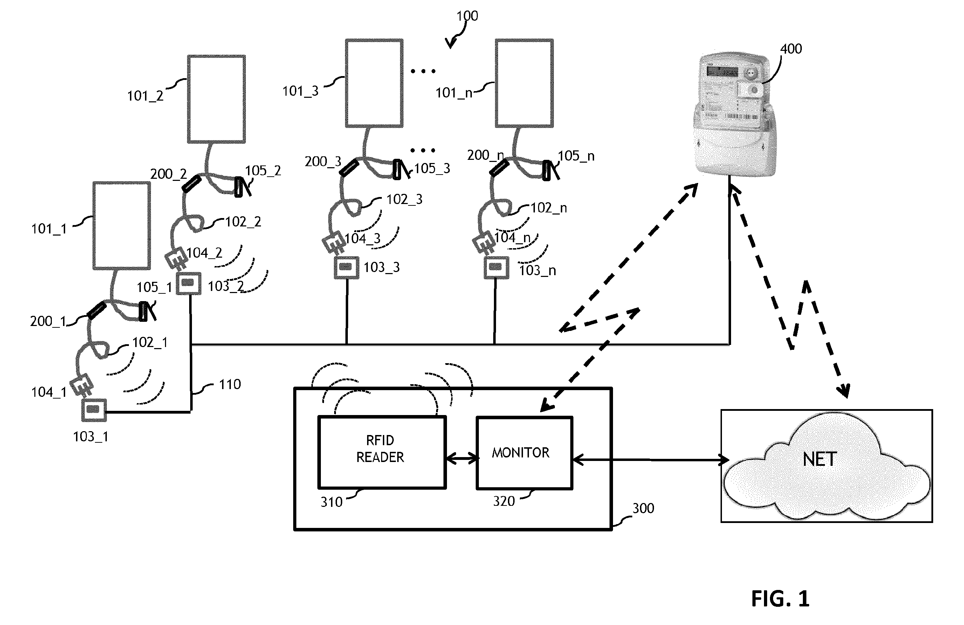

Figure 1 is a schematic block diagram of an electrical activity monitoring system in which one or more embodiments of the invention may be implemented. The electrical activity monitoring system 100 monitors the change in electrical status of n electrical devices 101_1 to 101_n. Each electrical device 101_1 to 101_n is connected by means of a respective electrical power cable 102_1 to 102_n to a power outlet 103_1 to 103_n of an electrical power supply network 110. It will be appreciated that while in the illustrated embodiment of Figure 1 each electrical device 101_1 to 101_n is connected to a respective power outlet 103_1 to 103_n, in other embodiments of the invention a plurality of electrical devices may be connected to the same power outlet 103_x.

Each electrical power cable 102_1 to 102_n is provided with a respective plug 104_1 to 104_n for connecting the respective electrical power cable to a respective power outlet 103_1 to 103_n for connection to the power supply network 110. Each electrical power cable is fitted with a respective in-line switch 105_1 to 105_n enabling the respective electrical device 101_1 to 101_n to be switched between electrical power states, such as between an electrical ON state and an electrical OFF state when the electrical power cable is connected to the power supply network 110.

Each electrical power cable 102_1 to 102_n is further provided with a respective RFID tag unit 200_1 to 200_n. The RFID tag units 200_1 to 200_n are attached to their respective power cable 102_1 to 102_n at a location between the respective in-line switch 105_1 to 105_n and the respective plug 104_1 to 104_n. An RFID tag unit may also be referred to as an RFID label, an RFID transponder and the like.

The electrical activity monitoring system 100 further includes an electrical activity monitoring apparatus 300. The power supply network 110 is typically provided with an electricity meter 400 for measuring electrical consumption in the power supply network 110. The electrical activity monitoring apparatus 300 may be connected to a communication network NET such as an Internet network so that data on the electrical activity of the system may be transmitted to a remote device, such as a remote electrical activity monitoring device for example the server of a remote an electrical activity monitoring service or an electricity power supplier company.

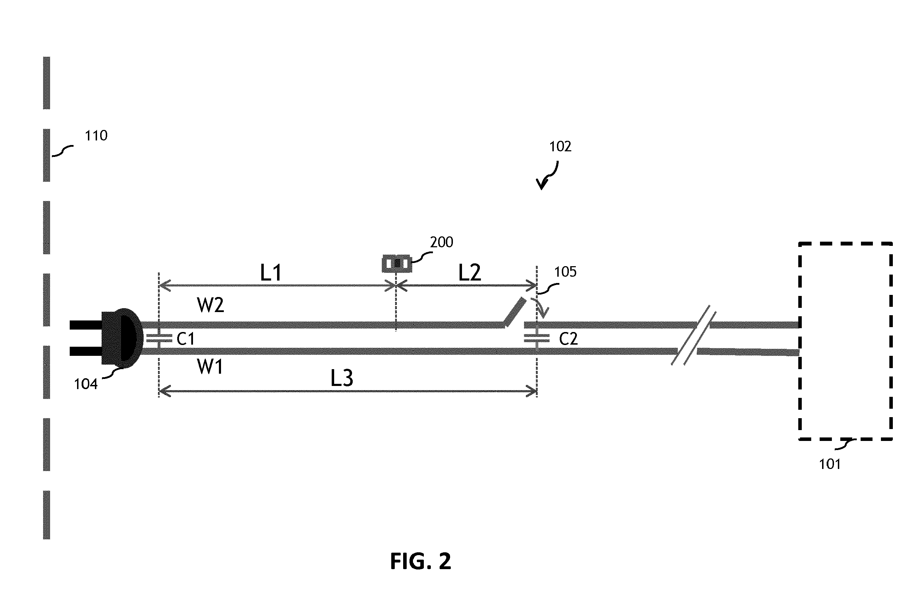

Figure 2 schematically illustrates an electrical activity monitoring device in accordance with an embodiment of the invention. The electrical activity monitoring device comprises a power cable 102, for supplying power to the respective electrical device 1 01_x from the power supply network 110 and an RFID tag device 200. The power cable is fitted with a respective in-line switch 105_x enabling the electrical device to be switched ON or OFF when the power cable is connected via electrical plug 104_x to the power supply 110.

The power cable comprises a pair of parallel conducting wires W1 and W2 that, in the UHF frequency range of the RFID sensor device 200, operate as a TEM transmission line between the in-line switch 105_x and the electrical plug 104_x. When the length L3 of the transmission line between the in-line switch 105_x and the electrical plug 104_x is properly sized with respect to the wavelength of the operating UHF frequency of the RFID sensor device 200 and a capacitive load is provided at each end (at the end where the power cable is connected to the power supply network and at the end where the in-line switch is located), a standing wave is established in the transmission line between the two impedance loads and the corresponding current is radiated from the power cable 102 in such a way that the power cable behaves as an antenna.

The length L3 of the power cable between the in-line AC switch 105 and the electrical plug 104 is sized so that it corresponds to the resonant length at the operating UHF frequency band of the RFID sensor device 200.

As capacitive loads two high voltage capacitors C1 and C2 are placed between the 2 wires W1 and W2. One capacitor C1 is located at the electrical plug 104 and the other capacitor is located at the in-line AC switch 105 to provide impedance loads at each end of the transmission line. The value of each capacitor C1, C2 is sufficiently high (typically C=0.1 $\mu$F) so that a short-circuit is imposed at the operating UHF frequency of the RFID sensor device 200 (for example f=900 MHz). These short circuits enable the impedance to be controlled at fixed points minimising the effect of unknown loads at both ends - beyond the in-line switch 105 towards the electrical device and beyond the electrical plug 104 towards the powerline infrastructure. The RFID tag device 200 is positioned between the electrical plug 104 and the in-line switch 105, at a distance L1 from the electrical plug 104 and a distance L2 from the in-line switch The antenna element 210 of the RFID tagdevice comprises a coupling loop tuned, for example in this particular embodiment, at a frequency of 900 MHz and located at a distance L2 from the in-line switch 105 and a distance L1 from the electrical plug 104 such that:

- When the in line AC switch 105 of the power cable 102 is open so that the electrical appliance 101 is in an OFF state, the electrical plane corresponding to the location of the RFID tag device 200 is equivalent to an open circuit such that the magnetic field is minimal and the coupling loop the antenna element 210 of the RFID sensor device 200 is not coupled to the transmission line. This occurs when:
  - 

$$L2 = k2 \text{ x } \lambda/2; \qquad (1)$$

  - 

$$L1 = k1 \text{ x } \lambda/2 + \lambda/4; \qquad (2)$$

    Where k1, k2 are integers and $\lambda$ is the guided wavelength corresponding to the operating UHF frequency of the RFID sensor device 200.

- When the in line AC switch 105 of the power cable 102 is closed so that the electrical device 101 is in an ON state, the electrical plane corresponding to the location of the corresponding RFID sensor device 200 is equivalent to a short -circuit so that the magnetic field is maximal and the coupling loop of the antenna element 210 is strongly coupled to the transmission line of the power cable 102. This occurs for the same values of distances L1 and L2 as defined in expressions (1) and (2). Furthermore, in order for the power cable between the AC switch 105 and the plug 104 to efficiently radiate, the length L3 of power cable between the AC switch 105 and the plug 104 should be approximately equal to an integer number of half-wavelengths:
  - 

$$L3 = k3 \text{ x } \lambda/2; \qquad (3)$$

where k3 is an integer and λ is the guided wavelength corresponding to the operating frequency of the RFID sensor device 200.

By setting L3=L1+L2 and taking into account expressions (1), (2) and (3), the following relation is obtained:

$$2(k2 + k1) + 1 \# 2k3; \text{ where } k1, k2 \text{ and } k3 \text{ are integers;}$$

this relation may be approached as far as k1 and k2 are sufficiently high.

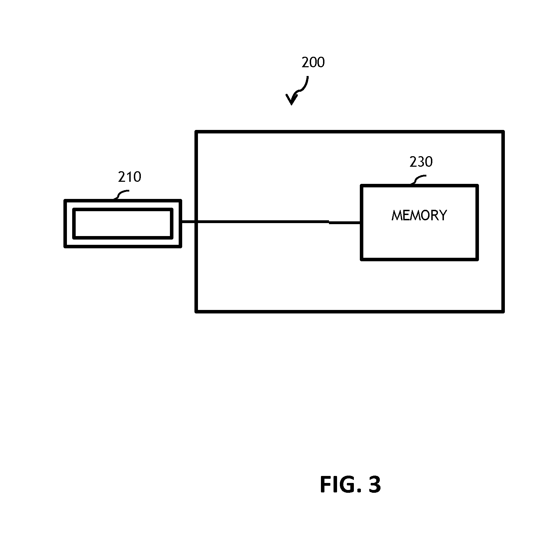

Figure 3 is a schematic functional block diagram of the RFID tag device of Figure 2 200 in accordance with an embodiment of the invention.

The RFID sensor device 200 comprises an antenna 210, and a memory chip 230 for storing identification data identifying the RFID sensor device. Each RFID sensor device 200 in the electrical monitoring system 100 is provided with an identification code enabling it to be identified by the monitoring device 300.

The antenna 210 of an RFID sensor unit 200_x is configured to magnetically couple with the respective power cable 102_x when the corresponding electrical device 1 01_x is switched ON by the respective in-line switch 105. When activated, the antenna 210 transfers data from the memory chip 230 to the respective power cable 102 by coupling and the data is transmitted wirelessly by means of the power cable 102, acting as an antenna, to an RFID reader of the monitoring device 300.

For example the RFID tag device 200 in this embodiment is a near field/short range RFID tag operating in the UHF frequency band, for example in the range from 800 MHz to 960 MHz, for instance in the region of 860 MHz or 900 MHz, or in the region of 433MHz or in the HF frequency band, for example in the region of 13.6MHz.

RFID is considered as a non specific short range device. It can use frequency bands without a license. Nevertheless, RFID should typically be compliant with local regulations (ETSI, FCC etc.)

- LF : 125 kHz - 134,2 kHz : low frequencies,
- HF: 13.56 MHz: high frequencies,
- UHF : 860 MHz - 960 MHz : ultra high frequencies,
- SHF : 2.45 GHz : super high frequencies

Transmission of the data from the RFID tag device 200 may be carried out by backscattering in response to an interrogation from the RFID reader received via the power cable.

In the case of a passive type RFID tag the antenna 210 acts as a power-coupling inductor which can harvest electrical power from the coupling between the antenna and the power cable to operate the modules of the RFID sensor device 200, such as the memory chip 230. Since the RFID tag device 200 in such an embodiment is a passive RFID tag device, energy consumption can be minimized since power is not being supplied constantly to the RFID tag device 200 from a power supply such as a battery. It will be appreciated, however, that in alternative embodiments of the invention the RFID tag device 200 may be an active type RFID tag powered by its own power supply means or a battery assisted passive type RFID tag.

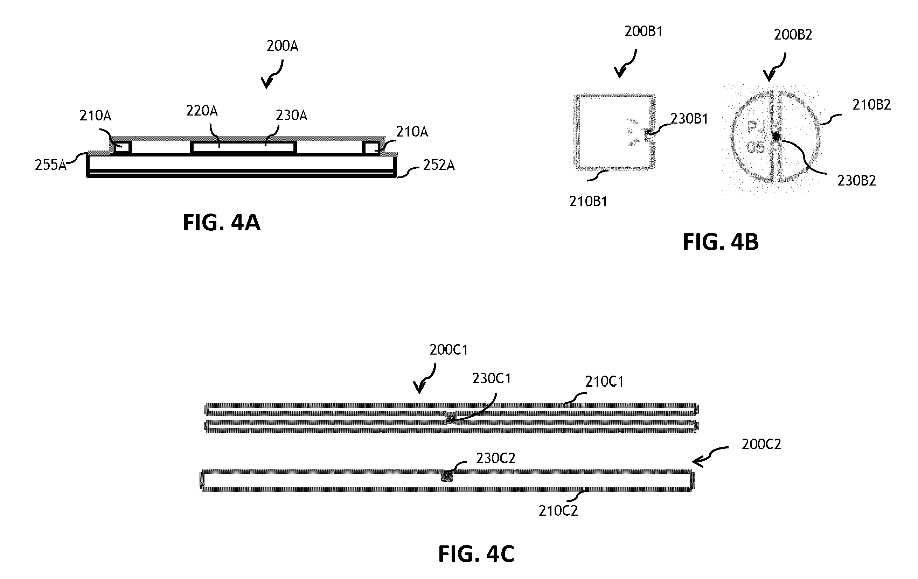

In embodiments of the invention the RFID tag is attached to the respective power cable 102_x at a location between the respective in-line switch 105_x and the plug 104_x end of the power cable 102_x. The RFID tag device 200 may be attached to the respective power cable 102_x by any form of fixation means such as for example by adhesive such as glue, sticking tape, or a sticker, by a mechanical connection such as for example staples, screws, nails; or by being embedded in the insulating sheath cover of the respective power cable 102_x. In one particular embodiment, as illustrated in Figure 4A, the RFID tag device 200A is provided in the form of a sticker with adhesive material 252A provided on the underside of the sticker to attach the sticker to the respective power cable 102_x while the antenna 210A, and memory chip 230A are provided on the topside of the sticker and covered by a protective cover layer 255A.

In some embodiments of the invention the antenna 210 may be shaped to fit around at least part of the power cable 102_x. In some embodiments of the invention, the antenna 210 of the RFID tag device 200 is in the form of a loop antenna and in use is arranged around at least part of the respective power cable 102_x

Figure 4B schematically illustrates examples of a commercial off the shelf (COTS) RFID near field UHF tags 200B1 and 200B2 suitable for performing the dual functions of current pulse detection and data transmission. Each RFID tag 200B1 and 200B2 respectively comprises a loop antenna element 210B1 and 210B2, and an RFID memory chip 230B1 and 230B2. The RFID tags 200B1 and 200B2 are attached to the respective cable 102-x with the respective antenna element 210B1 and 210B2 being arranged around at least part of the respective cable 102_x. In such a configuration the antenna 210B1 or 210B2 may be attached to the exterior of the cable or embedded in the cable.

Figure 4C schematically illustrates examples of a RFID tag 200C1 and 200C2 respectively provided with loop antennas 210C1, 210C2 and memory chips 230C1 abd 230C2 which may be employed in a particular embodiment of the invention. The shapes of the loop antennas 210C1; 210C2 are configured the form factor of the power cable. This helps to ensure magnetic coupling with the current flow at HF or UHF frequencies.

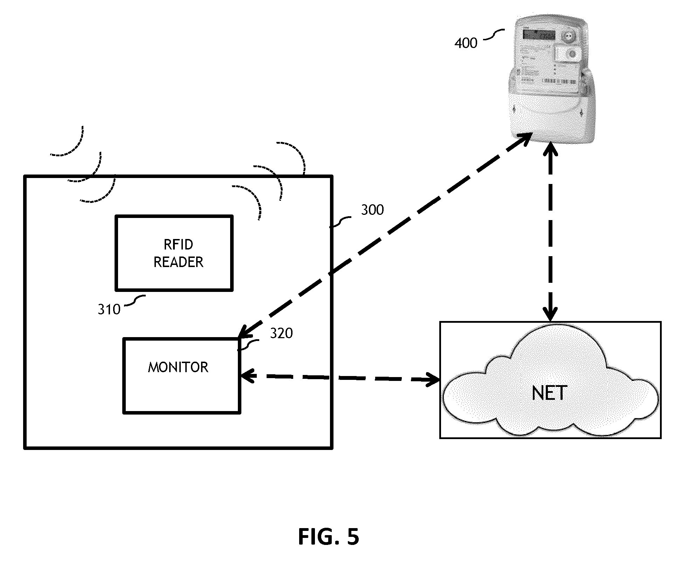

Figure 5 is a block diagram schematically illustrating an electrical activity monitoring apparatus 300 in accordance with an embodiment of the invention. The electrical activity monitoring apparatus 300 comprises an RFID reader device 310 and a monitoring device 320 for processing RFID data signals.

The RFID reader device 310 is a far field RFID type reader and is configured to wirelessly receive RFID data signals transmitted from the RFID tags200 of the network via wireless transmission from their respective power cables 102 and to send RFID interrogation signals to the RFID sensors 200 via wireless transmission to the respective power cables 102.

Monitoring device 320 receives data from the RFID reader device 310 indicative of the ON/OFF electrical activity status of the electrical devices 101_1 to 101_n in the electrical activity monitoring system 100.

In operation, the electrical activity monitoring system operates as follows. When an in line AC switch 105_x of a power cable 102_x is closed to switch on the corresponding electrical device 101_x, the antenna element 210 of the corresponding RFID tag device 200_x is magnetically coupled to the radiating power cable 102_x and the transmission line formed by the power cable 102_x between the in-line AC switch 105 and the electrical plug 104 radiates efficiently. RFID identification data can be transferred from the antenna element 210 to the power cable 102_x, and then radiated wirelessly to the RFID reader 310 by the radiating power cable 102_x acting as an antenna. The RFID tag device 200_x is thus visible to the RFID reader 310 of the electrical activity monitoring apparatus 300. On receiving RFID identification data the monitor device 320 is alerted that the corresponding electrical device 1 01_x has been switched ON.

When the in line AC switch 105_x is opened to switch off the electrical appliance 101_x, the antenna element 210 of the RFID tag device200_x is no longer coupled (or poorly coupled) to the power cable 102_x, and the power cable 102_x does not radiate (or radiates very inefficiently). Consequently data transmission to the RFID reader 310 does not take place. In effect the RFID tag device 200 is invisible to the RFID reader device 310. Thus the RFID reader 310 receives no further information from the RFID tag device 200_x. The lack of RFID data can be used to indicate to the monitor 330 that the electrical appliance 101_x is switched off.

In some embodiments of the invention the RFID reader device 310 is permanently in a state by which it can receive RFID identification information transmitted wirelessly from the RFID tag devices 200 of the network. Thus at any point in time the monitor device 320 connected to the RFID reader 310 can be informed as to which electrical devices 101_1 to 101_n are in an ON state (those for which identification data of the corresponding RFID sensor 200 is received) and which electrical devices 101_1 to 101_n are in an OFF state.

In some embodiments of the invention the RFID reader device may be periodically activated to determine which electrical devices are switched on. In other embodiments of the RFID reader device may be triggered by a detected increase in power consumption measured by electricity meter 400 in order to determine which electrical devices are switched on.

In one particular embodiment of the invention, the power consumed by an electrical device 1 01_x may be determined, for example by detecting the electrical device being switched on 101_x by means of transmission of the corresponding RFID data from the respective power cable 102_x and then determining the duration of time for which the electrical device is placed in an ON state i.e. assessing the amount of time until the corresponding RFID sensor 200_x becomes invisible because the power cable 102_x no longer wirelessly transmits the RFID data. Data representative of the power consumption for the different electrical devices 101_1 to 101_n of the system may thus be obtained

The electrical status change data or electrical consumption data may be processed to provide relevant information on electrical activity of the power network 110, such as for example to build a household user profile, to detect and warn of increased electrical power consumption, and/or to provide recommendations for reducing energy consumption. Moreover the relevant information on electrical activity of the power network 110 may be used as a security measure to alert when a particular electrical device has been switched ON, or has been switched off.

In some embodiments of the system the monitoring apparatus 300 may be part of a home gateway system connected to an external internet network NET. Real time tracking of the total home power consumption could be provided by the home electricity provider or any other electrical activity monitoring service via the internet network. For example the electricity provider could trigger reading phases of the RFID reader by transmitting signals from a remote server via the gateway device to determine which electrical devices 101_1 to 101_n are switched on by detecting the visible RFID tag devices101_1 to 101_n.

In one particular embodiment of the invention the monitoring device 330 is connected to a smart type electricity meter 400 connected to the power supply network 110 of the system. The electricity meter 400 and the monitoring 330 device may be connected to one another by a wireless or wired connection. The smart electricity meter 400 is configured to monitor the power consumption of electrical devices 101_1 to 101_n connected to the power network 110. The smart electricity meter 400 is configured to detect a change in power consumption: for example an increase in the rate of power consumption which may result from the switching ON of one or more electrical devices 101_1 to 101_n supplied by the power network 110, or a decrease in the rate of power consumption which may result from the switching OFF of one or more of the electrical devices 101_1 to 101_n supplied by the power network 110. In response to the detected change in power consumption a command signal is transmitted from the monitoring device 330 to the RFID reader device 310 to activate an RFID reading process. The RFID reader device 310 in response to the command signal is activated to receive RFID identification data from any RFID tag device 200 which is able to transmit the RFID identification data via the corresponding power cable 102_x acting as an antenna since the respective in-line switch 105_x is in an ON position and the power cable 102-x acts as a radiating transmission line between the in-line switch 105_x and the plug 104_x.

The RFID identification data is received and processed by the RFID reader device 310 and transferred to the monitor device 320.

Monitoring device 320 can determine which electrical devices are switched on and in some particular embodiments transmit such information to a remote device connected via a communication network.

Although the present invention has been described hereinabove with reference to specific embodiments, the present invention is not limited to the specific embodiments, and modifications will be apparent to a skilled person in the art which lie within the scope of the present invention.

For instance, while the foregoing examples have been described with respect to a household power network system, it will be appreciated that embodiments of the invention may be applied to any power network to which electrical devices are connected. Moreover the system could be applied in security or safety applications to identify electrical devices which have been switched on or switched off.

Many further modifications and variations will suggest themselves to those versed in the art upon making reference to the foregoing illustrative embodiments, which are given by way of example only and which are not intended to limit the scope of the invention, that being determined solely by the appended claims. In particular the different features from different embodiments may be interchanged, where appropriate.

**Claims**

1. An electrical activity sensor device for monitoring the electrical status of an electrical device (101), the electrical activity sensor device comprising:

   a power cable (102) for supplying power to an electrical device (101) from a power supply network, the power cable being fitted with an in-line switch (105) enabling the electrical device (101) to be switched between electrical power states;
   an RFID tag device (200) attached to the power cable (102) of the electrical device (101), between the end of the power cable, connectable to the power supply, and the in-line switch, the RFID tag device (200) including:

   an antenna element (210) operable to magnetically couple with the power cable (102) when the electrical device (101) is in an ON power state a memory element (230) for storing identification data identifying the RFID tag device (200);

   wherein the power cable (102=is configured to operate as an antenna, when the electrical device (101) is switched on, to transmit the identification data from the RFID tag device (200) wirelessly to an RFID reader.

2. A device according to claim 1, wherein the power cable (102), between the in-line switch (105) and the end of the power cable (102) connectable to the power supply is configured to operate as a TEM transmission line in the operating frequency range of the RFID tag device (200) when the electrical device (101) is switched on.

3. A device according to claim 2 wherein the power cable (101) comprises a pair of electrically conductive wires (W1, W2) connected in parallel with a capacitive load (C2) provided at the in-line switch (105) and a capacitive load (C1) provided at the end of the power cable (102) connectable to the power supply network.

4. A device according to any preceding claim, wherein the length of the power cable (102) between the in-line switch (105) and the end of the cord connectable to the power supply network is sized based on the operating frequency range of the RFID tag device (200).

5. A device according to claim 4 wherein the said length corresponds to the resonant wavelength of the operating frequency of the RFID tag device (200).

6. A device according to claim 4 wherein the said length L3 is determined based on the following expression:

$$L3 = k3 \times \lambda/2;$$

where k3 is an integer and $\lambda$ is the guided wavelength corresponding to the operating frequency of the RFID tag device (200).

7.  A device according to any preceding claim wherein the RFID tag device (200) is attached to the power cable (102) at a first distance *L1* from the end of the cable connectable to the power supply network and at a second distance L2 from the in-line switch (105) such that

    •

    $$L2 = k2 \times \lambda/2;$$

    •

    $$L1 = k1 \times \lambda/2 + \lambda/4;$$

    where k1, k2 are integers and $\lambda$ is the guided wavelength corresponding to the operating frequency of the RFID tag device (200).

8.  A device according to claim 7, when dependent on claim 6, wherein the said length L3 and the first distance L1 and the second distance L2 are selected based on the following expression:

    $$2(k2 + k1) + 1 \# 2k3$$

9.  A device according to any preceding claim wherein the RFID tag device (200) comprises a near field RFID tag.

10. A device according to any preceding claim, wherein the antenna element (210) is formed as a loop antenna.

11. A device according to any preceding claim wherein the RFID tag device (200) is operable as a passive RFID tag powered by electromagnetic induction via the power cable.

12. An electrical activity monitoring apparatus (300) for monitoring the electrical status of at least one electrical device (101) connected to a power supply network by a respective power cable (102) and, the electrical activity monitoring apparatus (300) comprising:

    an RFID reader module (310) for reading RFID identification data from at least one RFID tag device (200), each RFID tag device (200) being attached to a respective power cable of an electrical device between the end of the power cable (102) connectable to the power supply network and an in-line switch (105) fitted to the power cable (102) to switch the electrical device (101) between electrical power states wherein the identification data is received from the respective RFID tag device via wireless transmission from the power cable (102) to which the RFID tag device (200) is attached when the electrical device is in an ON power state; and
    a monitor device (320) for determining from the RFID identification data received by the RFID reader module, which electrical devices of the network are switched on.

13. An apparatus according to claim 12, wherein the RFID reader module (310) is configured to read signals from the at least one RFID tag (200) in response to a detected change in power consumption measured by an electricity meter connected to the power supply network.

14. An apparatus according to claim 12 or 13 comprising a communication network interface for connecting with a communication network such that data may be transmitted to or received from a remote server connected to the communication network.

15. A gateway system comprising an electrical activity monitoring apparatus according to any one of claims 12 to 14.

FIG. 1

FIG. 2

**FIG. 3**

EP 2 916 464 A1

FIG. 4A

FIG. 4B

FIG. 4C

FIG. 5

Europäisches
Patentamt
European
Patent Office
Office européen
des brevets

# EUROPEAN SEARCH REPORT

Application Number

EP 14 30 5312

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2012/280828 A1 (KIM MOON J [US]) 8 November 2012 (2012-11-08) * the whole document * | 1-15 | INV. H04B3/54 G01D4/00 |
| Y | GB 2 489 517 A (SEAMLESS SENSING LTD [GB]) 3 October 2012 (2012-10-03) * abstract; figures 1-4 * | 1-15 | |
| Y | WO 2013/109247 A1 (THOMSON LICENSING [FR]; FUNK JOHN DAVID [US]; BAJGROWICZ BRIAN DAVID []) 25 July 2013 (2013-07-25) * the whole document * | 1-15 | |
| Y | OAKLEY MCDONALD WOODWARD ET AL: "LINE CORD ANTENNA WITH IMPROVED DIPOLE-LIKE PERFORMANCE", R.C.A.TECHNICAL NOTES,, no. 1335, 1 October 1983 (1983-10-01), pages 1-2, XP001388967, * the whole document * | 1-15 | |

TECHNICAL FIELDS SEARCHED (IPC)

H04B
G01D

The present search report has been drawn up for all claims

| Place of search | Date of completion of the search | Examiner |
|---|---|---|
| Munich | 29 October 2014 | Kallinger, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 14 30 5312

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2014

| Patent document cited in search report | Publication date | Patent family member(s) | Publication date |
|---|---|---|---|
| US 2012280828 A1 | 08-11-2012 | NONE | |
| GB 2489517 A | 03-10-2012 | NONE | |
| WO 2013109247 A1 | 25-07-2013 | NONE | |

EPO FORM P0459

For more details about this annex : see Official Journal of the European Patent Office, No. 12/82